# EUROPÄISCHE PATENTSCHRIFT

(11) **EP 1 003 257 B1**
(45) Veröffentlichungstag und Bekanntmachung des Hinweises auf die Patenterteilung: **08.03.2006**
(21) Anmeldenummer: 99440318.6
(22) Anmeldetag: 16.11.1999
(51) Int. Cl.: H01S 5/062

(54) **Verfahren und Vorrichtung zum Erhöhen der Nutzungsdauer von Lasern**
Method and system for increasing the useful duration of a laser
Méthode et système pour prolonger la durée de vie utile d'un laser

(30) Priorität: 19.11.1998 DE 19853393
(43) Veröffentlichungstag der Anmeldung: 24.05.2000
(73) Patentinhaber: ALCATEL, 75008 Paris (FR)
(72) Erfinder: Heide, Josef, 73635 Rudersberg (DE)
(74) Vertreter: Rausch, Gabriele

(56) Entgegenhaltungen:
- WO-A-93/02493
- US-A- 4 872 080
- PATENT ABSTRACTS OF JAPAN vol. 1995, no. 08, 29. September 1995 (1995-09-29) & JP 07 131093 A (FANUC LTD), 19. Mai 1995 (1995-05-19)
- PATENT ABSTRACTS OF JAPAN vol. 010, no. 228 (E-426), 8. August 1986 (1986-08-08) & JP 61 063074 A (MATSUSHITA ELECTRIC IND CO LTD), 1. April 1986 (1986-04-01)
- PATENT ABSTRACTS OF JAPAN vol. 009, no. 047 (E-299), 27. Februar 1985 (1985-02-27) & JP 59 186384 A (CANON KK), 23. Oktober 1984 (1984-10-23)

## Beschreibung

Die Erfindung betrifft ein Regelungsverfahren für einen Laser oder optischen Verstärker, dessen elektrische Betriebsleistung zur Vermeidung einer mit der Zeit abnehmenden optischen Ausgangsleistung des Lasers bzw. optischen Verstärkers erhöht wird, wobei die maximal zulässige Betriebsleistung nach oben begrenzt ist und wobei der Laser bzw. optische Verstärker auf Alterung überwacht wird, sowie einen entsprechenden optischen Sender (Lasersender) mit einem Laser oder einem optischen Verstärker, einer Regelung für die Betriebsleistung, einer die Betriebsleistung nach oben begrenzenden Begrenzungsschaltung und einer Alterungsüberwachung des Lasers bzw. optischen Verstärkers.

Es ist bekannt, daß sich die Kennlinien von Lasern unter der Wirkung von verschiedenen Einflüssen verändern, z.B. aufgrund von Veränderungen im Kristall, Temperatureinflüssen (vor allem bei ungekühlten Lasern) und Alterung. Gegen diese Einflüsse müssen Vorstrom (Laserstrom) und Modulation mit Hilfe von Regelschaltungen nachgeregelt werden. Die optischen Werte des Lasers werden konstant gehalten, indem der Strom verändert wird.

Damit die Regelschaltungen arbeiten können, muß die Laservorrichtung, z.B. ein Lasersender, so dimensioniert sein, daß bei Raumtemperatur und neuem Gerät ausreichende Stromreserven zum Nachregeln bestehen. Gleichzeitig bestehen bei Lasersendern Anforderungen an die Augensicherheit: Damit beim Bedienpersonal keine irreversiblen Schäden an den Augen auftreten können, falls jemand in ein Faserende blickt, muß dafür gesorgt werden, daß die optische Ausgangsleistung des Lasers auf ungefährliche Werte begrenzt wird. Die Grenzwerte sind in internationalen Normen festgelegt. Die Anforderungen für Regelreserve und Augensicherheit sind gegensätzlich: Während sich die Ausgangsleistung zur Ausreglung von Einflüssen durch die Regelschaltung noch möglichst weit erhöhen lassen sollte, verlangt die Augensicherheit die Begrenzung der Ausgangsleistung möglichst knapp über dem geforderten Wert, der sich seinerseits an den Laserschutzklassen orientiert. Zusätzlich muß die Begrenzung der Ausgangsleistung vor allem für den Fall von Fehlern in der Ansteuerelektronik sichergestellt werden: Bestimmte Grenzwerte dürfen auch im Fall von Einzelfehlern in Bauelementen nicht überschritten werden, z.B. wenn zwischen Emitter und Kollektor eines Treibertransistors ein Kurzschluß auftritt oder wenn die Regelschaltung ausfällt.

Um die Begrenzung der optischen Ausgangsleistung auch in diesen Fällen sicherzustellen, wird eine zusätzliche Strombegrenzung durch ein hoch zuverlässiges Bauelement, z.B. einen Widerstand, vorgesehen, der so dimensioniert ist, daß auch unter worst-case-Bedingungen (Laser mit der steilstmöglichen Kennlinie gemäß Datenblatt, Laserchip auf tiefstmöglicher Temperatur, Betriebsspannung an der oberen Grenze usw.) die maximale Ausgangsleistung nicht überschritten wird. Leider stehen diese Maßnahmen im Gegensatz zu der Forderung, daß bei fehlerfreier Ansteuerelektronik die Ausgangsleistung noch möglichst weit über den bei einem neuen Lasersender auftretenden Wert hochgeregelt werden kann, um Einflüsse auszuregeln. Das ist erforderlich, weil der Laser im Laufe der Betriebsdauer altert, wobei die Loserkennlinie immer flacher wird. Die Regelschaltung kann die Ausgangsleistung nur soweit nochregeln, wie keine Begrenzungen zur Sicherstellung der Lasersicherheit wirken. Das heißt, die Nutzungsdauer eines Lasers bzw. optischen Verstärkers ist nicht nur durch seine Alterung, sondern auch durch die der Augensicherheit dienende Begrenzung seiner Ausgangsleistung bestimmt.

Üblicherweise wird die Alterung des Lasers, z.B. seine Betriebsdauer, überwacht und ein (meist als "nicht dringend" klassifizierter) Alterungs-Alarm erzeugt, der den Betreiber darauf hinweisen soll, daß der Laser demnächst nicht mehr seine volle Ausgangsleistung bringen wird und schon einmal ein Ersatzgerät bereitgestellt werden sollte.

Ein Laser mit Alterungsüberwachung wird beispielsweise in JP 07 131 093 A (FANUC LTD), 19. Mai 1995 offenbart.

Der Erfindung liegt daher die Aufgabe zugrunde, ein Regelungsverfahren der eingangs genannten Art derart weiterzubilden, daß die Nutzungsdauer (Lebensdauer) des Lasers bzw. optischen Verstärkers verlängert werden kann, sowie einen entsprechenden optischen Sender bereitzustellen.

Diese Aufgabe wird bei dem eingangs genannten Regelungsverfahren erfindungsgemäß dadurch gelöst, daß die Leistungsalterung des Lasers bzw. optischen Verstärkers erfaßt wird und daß die Obergrenze für die maximal zulässige Betriebsleistung des Lasers bzw. Verstärkers mit zunehmender Leistungsalterung erhöht wird.
Mit zunehmender Alterung des Lasers bzw. des optischen Verstärkers wird dessen Kennlinie immer flacher. Deswegen können - auch unter Sicherheits-Gesichtspunkten - für die Leistungsbegrenzung auch höhere Ströme zugelassen werden. Erfindungsgemäß wird daher die Leistungsalterung des Lasers erfaßt und die Leistungsbegrenzung, die im allgemeinen eine Begrenzung des Betriebsstroms (Laserstroms) sein wird, in Abhängigkeit von der Leistungsalterung nach und nach zurückgenommen. Diese Maßnahme hat den Vorteil, daß z.B. ein Lasersender mit einer viel größeren effektiven Alterungsreserve als bisher versehen werden kann und damit eine längere Nutzungsdauer erhält.

Natürlich erfordert das Erfassen und Verarbeiten der Leistungsalterung weitere Hardware im optischen Sender, die rechnerisch auch Einfluß auf die Lasersicherheit hat, weil auch sie ausfallen kann. Nach den gültigen Sicherheits-Normen wird aber nur der Fall von "Einzelfehlern" betrachtet. Gleichzeitige Mehrfach-Ausfälle können ohnehin nicht lückenlos abgedeckt werden.

Die Erweiterung der Alterungsreserve ist nicht nur bei den eigentlichen Lasern anwendbar, sondern ebenso auch bei optischen Verstärkern, bei denen die Pumplaser nicht direkt auf einen Ausgang senden, sondern die Energie auf eine andere Wellenlänge umgesetzt wird (z.B. von 980 nm auf 1550 nm). Dieser Anwendungsfall ist eigentlich der Wichtigere, weil in, optischen Verstärkern sehr hohe optische Leistungen auftreten.

In einer besonders bevorzugten Verfahrensausgestaltung wird eine Erhöhung der Obergrenze erst nach einer Konsistenzprüfung der erfaßten Leistungsalterung mit anderen erfaßten Parametern des Lasers bzw. optischen Verstärkers zugelassen. Durch diese Konsistenzprüfung möglichst aller überwachten Parameter der Baugruppe, die z.B. durch einen internen Überwachungsrechner (Prozessor) vorgenommen werden kann, läßt sich sicherstellen, daß die Leistungs- oder Strombegrenzung nicht fälschlicherweise auf einen Fehler in der Überwachung hin zurückgenommen wird und nicht gefährlich hohe Ausgangsleistungen emittiert werden könnten. Die Obergrenze wird nur dann erhöht, wenn keine Widersprüche zwischen den einzelnen Parametern vorliegen, so daß davon ausgegangen werden kann, daß die Baugruppe ordnungsgemäß arbeitet.

Vorzugsweise wird, da der momentane Betriebsstrom durch einen Laser von dessen Betriebstemperatur abhängt, als einer der anderen Parameter die Betriebstemperatur des Lasers bzw. optischen Verstärkers erfaßt, die dann bei der Rücknahme der Leistungs- bzw. Strombegrenzung mitausgewertet wird. Der erforderliche Meßfühler (z.B. NTC-Widerstand) ist ein billiges Bauelement, und die Bewertung der Temperatur durch den Überwachungsrechner stellt softwaremäßig kein Problem dar.

Als weitere Sicherheitsmaßnahme kann eine Erhöhung der Obergrenze erst nach einer bestimmten Betriebsdauer des Lasers bzw. optischen Verstärkers zugelassen werden. Dazu kann der interne Überwachungsrechner z.B. einen Betriebsstundenzähler oder eine Real-Time-Clock auswerten.

Damit der neue Wert einer Strombegrenzung nach einer Abschaltung nicht neu aktivieren werden muß, sollte der neue (erhöhte) Wert der Obergrenze jeweils abgespeichert werden. Ein solcher Datenspeicher (z.B. ein EEPROM) ist ohnehin meist vorhanden, so daß z.B. ein Lasersender die neuen Werte der Strombegrenzung hardwaremäßig übernehmen kann.

Weitere Sicherheit gegen unzulässige und damit gefährliche Arbeitspunktänderungen kann dadurch gewonnen werden, daß eine Erhöhung der Obergrenze jeweils nur in mehreren kleinen Schritten und nicht in einem einzigen Schritt vorgenommen wird. Der Vorgang muß dann zwar mehrfach wiederholt werden, was aber keinen Nachteil darstellt.

Die oben genannte Aufgabe wird bei dem eingangs genannten optischen Sender durch eine Steuerungs- oder Regelungseinheit gelöst, die entsprechend der mit der Alterungsüberwachung erfaßten Leistungsalterung in der Begrenzungsschaltung die Obergrenze für die maximal zulässige Betriebs- bzw. Verleistung mit zunehmender Leistungsalterung erhöht.

In einer besonders bevorzugten Ausführungsform weist die Begrenzungsschaltung einen von der Steuerungs- oder Regelungseinheit einstellbaren Strombegrenzungswiderstand auf. Zum Beispiel können einem unveränderlichen Strombegrenzungswiderstand ein oder mehrere, von der Steuerungs- oder Regelungseinheit steuerbare Leistungs-FETs parallel geschaltet werden, um so den effektiven Strombegrenzungswiderstand zu verringern. Es ist allerdings auch einen Ausführungsform denkbar, bei der die die eingesetzten FETs als Schalter dienen, die einen oder mehrere parallele Widerstände zuschalten können.

Für die oben beschriebene Konsistenzprüfung kann eine Prüfeinheit vorgesehen sein, die die erfaßte Leistungsalterung auf Konsistenz mit anderen erfaßten Parametern des Lasers bzw. optischen Verstärkers überprüft und das Ergebnis an die Steuerungs- oder Regelungseinheit weiterleitet.

Weitere Vorteile der Erfindung ergeben sich aus der Beschreibung und der Zeichnung. Ebenso können die vorstehend genannten und die noch weiter aufgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigt:
- Fig. 1: schematisch ein Ausführungsbeispiel des erfindungsgemäßen optischen Senders;
- Fig. 2: schematisch eine in dem optischen Sender der Fig. 1 vorgesehene Begrenzungsschaltung; und
- Fig. 3: beispielhaft ein Ablaufdiagramm des erfindungsgemäßen Regelungsverfahrens zur Erhöhung der Nutzungsdauer eines Lasers.

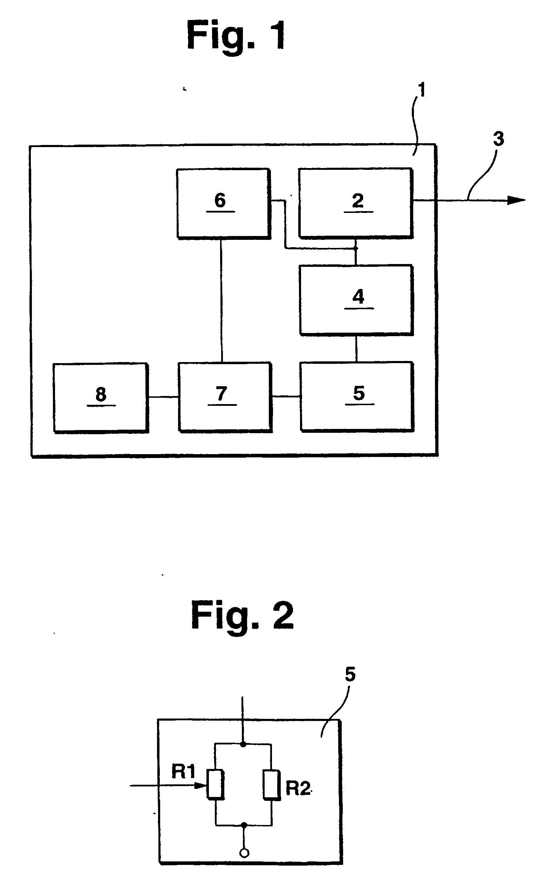

Der in Fig. 1 gezeigte optische Sender 1 umfaßt einen Laser 2 (z.B. eine Laserdiode), dessen optische Ausgangsleistung 3 mit Hilfe einer Regelung 4 für den Betriebsstrom des Lasers 2 geregelt wird. Die Obergrenze für den maximal zulässigen Betriebsstrom ist durch eine auf die Regelung 4 wirkende Begrenzungsschaltung 5 vorgegeben.

Die Leistungsalterung des Lasers 2 wird mit einer Alterungsüberwachung 6 erfaßt und an eine Steuerungs- oder Regelungseinheit 7 weitergeleitet, die die Obergrenze für den maximal zulässigen Betriebsstrom mit zunehmender Leistungsalterung erhöht. In einer Prüfeinheit 8 wird die erfaßte Leistungsalterung auf Konsistenz mit anderen erfaßten Parametern des Lasers 2 überprüft und das Ergebnis an die Steuer- oder Regelschaltung 7 weitergeleitet, die nur bei Konsistenz die Obergrenze entsprechend erhöht. Die Prüfeinheit 8 kann z.B. ein interner Überwachungsrechner (Prozessor) sein.

Wie in Fig. 2 gezeigt, weist die Begrenzungsschaltung 5 dazu einen unveränderlichen Widerstand R1 und einen parallel geschalteten, von der Steuerungs- oder Regelungseinheit 7 einstellbaren Widerstand R2, z.B. einen Leistungs-FET, auf. Indem dieser einstellbare Widerstand R2 mit steigender Leistungsalterung des Lasers 2 durch die Steuer- oder Regelschaltung 7 verringert wird, verringert sich der wirkende Strombegrenzungswiderstand, d.h., die maximal zulässige Obergrenze für den Betriebsstrom erhöht sich.

In einer anderen Ausführungsform ist der veränderliche Widerstand R2 gebildet aus einem festen Widerstand und einem FET in der Funktion als Schalter.
Weiterhin können auch mehrere veränderliche Widerstände Rn parallel geschaltet sein, wobei sowohl Ausführungsformen mit FETs als auch Ausführungsformen mit einer Kombination von festem Widerstand und FET als Schalter denkbar sind.

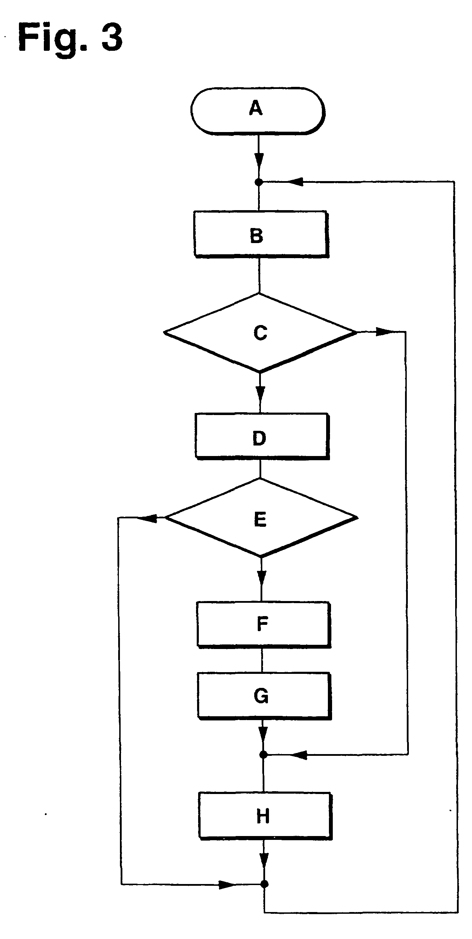

In Fig.3 ist beispielhaft ein Ablaufdiagramm (Programm) für das oben beschriebene Regelungsverfahren gezeigt. Nach dem Programmstart (Schritt A) wird in Schritt B die gewünschte optische Ausgangsleistung des Lasers 2 bzw. der dafür erforderliche Betriebsstrom ermittelt. In Schritt C wird geprüft, ob dieser erforderliche Betriebsstrom oberhalb der eingestellten Maximalgrenze des Betriebsstroms liegt. Im positiven Fall wird die Leistungsalterung des Lasers 2 ermittelt (Schritt D) und dann in Schritt E geprüft, ob die ermittelte Leistungsalterung mit anderen ermittelten Parametern des Lasers 2 konsistent ist.

Ist Konsistenz gegeben, so wird die Obergrenze für den Betriebsstrom entsprechend erhöht (Schritt F) und dieser Wert abgespeichert (Schritt G). In Schritt H wird schließlich der Laser 2 innerhalb dieser neuen Obergrenze angesteuert, und das Programm springt zurück zu Schritt B. Liegt in Schritt E hingegen keine Konsistenz vor, so verzweigt das Programm, ohne daß die Obergrenze erhöht wurde, unmittelbar zurück zu Schritt B, um den erforderlichen Betriebsstrom erneut zu berechnen.

Wenn in Schritt C festgestellt wird, daß der erforderliche Betriebsstrom die gesetzte Obergrenze nicht übersteigt, verzweigt das Programm unmittelbar zu Schritt H, um den Laser 2 entsprechend anzusteuern.

## Patentansprüche

1. Regelungsverfahren für einen Laser (2) oder optischen Verstärker, dessen elektrische Betriebsleistung zur Vermeidung einer mit der Zeit abnehmenden optischen Ausgangsleistung des Lasers (2) bzw. optischen Verstärkers erhöht wird, wobei die maximal zulässige Betriebsleistung nach oben begrenzt ist und wobei der Laser (2) bzw. optische Verstärker auf Alterung überwacht wird,
wobei die Leistungsalterung des Lasers (2) bzw. optischen Verstärkers erfaßt wird (D), **dadurch gekennzeichnet,**
**daß** die Obergrenze für die maximal zulässige Betriebsleistung mit zunehmender Leistungsalterung erhöht wird (F).

2. Regelungsverfahren nach Anspruch 1, **dadurch gekennzeichnet daß** eine Erhöhung der Obergrenze erst nach einer Konsistenzprüfung (E) der erfaßten Leistungsalterung mit anderen erfaßten Parametern des Lasers (2) bzw. optischen Verstärkers zugelassen wird.

3. Regelungsverfahren nach Anspruch 2, **dadurch gekennzeichnet, daß** als einer der anderen Parameter die Betriebstemperatur des Lasers (2) bzw. optischen Verstärkers erfaßt wird.

4. Regelungsverfahren nach einem der vorhergehenden Ansprüche,
**dadurch gekennzeichnet, daß** eine Erhöhung der Obergrenze erst nach einer bestimmten Betriebsdauer des Lasers (2) bzw. optischen Verstärkers zugelassen wird.

5. Regelungsverfahren nach einem der vorhergehenden Ansprüche,
**dadurch gekennzeichnet, daß** der Wert der erhöhten Obergrenze abgespeichert wird (G).

6. Regelungsverfahren nach einem der vorhergehenden Ansprüche,
**dadurch gekennzeichnet, daß** eine Erhöhung der Obergrenze um jeweils nur einen kleinen Betrag vorgenommen wird.

7. Optischer Sender (1) mit einem Laser (2) oder einem optischen Verstärker, einer Regelung (4) für die Betriebsleistung des Lasers (2) bzw. Verstärkers, einer die Betriebsleistung nach oben begrenzenden Begrenzungsschaltung (5) und einer Alterungsüberwachung (6) des Lasers (2) bzw. optischen Verstärkers,
**gekennzeichnet durch** eine Steuerungs- oder Regelungseinheit (7), die entsprechend der mit der Alterungsüberwachung (6) erfaßten Leistungsalterung in der Begrenzungsschaltung (5) die Obergrenze für die maximal zulässige Betriebsleistung mit zunehmender Leistungsalterung erhöht.

8. Optischer Sender nach Anspruch 7, **dadurch gekennzeichnet, daß** die Begrenzungsschaltung (5) einen von der Steuerungs- oder Regelungseinheit (7) einstellbaren Strombegrenzungswiderstand (R2) aufweist.

9. Optischer Sender nach Anspruch 8, **dadurch gekennzeichnet, daß** der steuerbare Strombegrenzungswiderstand (R2) parallel zu einem unveränderlichen Strombegrenzungswiderstand (R1) geschaltet ist.

10. Optischer Sender nach einem der Ansprüche 7 bis 9, **gekennzeichnet durch** eine Prüfeinrichtung (8), die eine erfaßte Leistungsalterung auf Konsistenz mit anderen erfaßten Parametern des Lasers (2) bzw. optischen Verstärkers überprüft und das Ergebnis an die Steuerungs- oder Regelungseinheit (7) weiterleitet.

## Revendications

1. Procédé de régulation pour un laser (2) ou un amplificateur optique dont la puissance électrique de fonctionnement est accrue pour éviter une puissance de sortie optique du laser (2) ou de l'amplificateur optique qui diminue dans le temps, la puissance de fonctionnement maximale admissible étant limitée vers le haut et le laser (2) ou l'amplificateur optique faisant l'objet d'une surveillance de son vieillissement,
le vieillissement du laser (2) ou de l'amplificateur optique étant relevé (D),
**caractérisé en ce**
**que** la limite supérieure de la puissance de fonctionnement maximale admissible et élevée (F) à mesure que le vieillissement de la puissance augmente.

2. Procédé de régulation selon la revendication 1, **caractérisé en ce qu'**une élévation de la limite supérieure n'est autorisée qu'après un contrôle de cohérence (E) du vieillissement de puissance relevé avec d'autres paramètres relevés du laser (2) ou de l'amplificateur optique.

3. Procédé de régulation selon la revendication 2, **caractérisé en ce que** l'un des autres paramètres relevés est la température de fonctionnement du laser (2) ou de l'amplificateur optique.

4. Procédé de régulation selon l'une des revendications précédentes,
**caractérisé en ce qu'**une élévation de la limite supérieure n'est autorisée qu'après une durée de fonctionnement donnée du laser (2) ou de l'amplificateur optique.

5. Procédé de régulation selon l'une des revendications précédentes,
**caractérisé en ce que** la valeur de la limite supérieure est mémorisée (G).

6. Procédé de régulation selon l'une des revendications précédentes,
**caractérisé en ce qu'**une élévation de la limite supérieure est à chaque fois effectuée d'une valeur donnée seulement.

7. Émetteur optique (1) comprenant un laser (2) ou un amplificateur optique, un régulateur (4) pour la puissance de fonctionnement du laser (2) ou de l'amplificateur optique, un circuit de limitation (5) qui limite la puissance de fonctionnement vers le haut et un dispositif de surveillance du vieillissement (6) du laser (2) ou de l'amplificateur optique,
**caractérisé par** une unité de commande ou de régulation (7) qui, en fonction du vieillissement de la puissance relevé avec le dispositif de surveillance du vieillissement (6), élève la limite supérieure de la puissance maximale autorisée de fonctionnement maximale admissible dans le circuit de limitation (5) à mesure que le vieillissement de la puissance augmente.

8. Émetteur optique selon la revendication 7, **caractérisé en ce que** le circuit de limitation (5) présente une résistance de limitation du courant (R2) réglable par l'unité de commande ou de régulation (7).

9. Émetteur optique selon la revendication 8, **caractérisé en ce que** la résistance de limitation du courant commandable (R2) est branchée en parallèle avec une résistance de limitation du courant non variable (R1).

10. Émetteur optique selon l'une des revendications 7 à 9, **caractérisé par** un dispositif de contrôle (8) qui vérifie la cohérence d'un vieillissement de puissance relevé avec d'autres paramètres relevés du laser (2) ou de l'amplificateur optique et qui transmet le résultat à l'unité de commande ou de régulation (7).

## Claims

1. Control method for a laser (2) or optical amplifier, the electrical operating power of which is increased in order to avoid an optical output power of the laser (2) or optical amplifier decreasing with time, wherein the maximum permissible operating power is limited upwards and wherein the laser (2) or optical amplifier is monitored for ageing, wherein the power ageing of the laser (2) or optical amplifier is detected (D), **characterised in that** the upper limit for the maximum permissible operating power is increased with increasing power ageing (F).

2. Control method according to Claim 1, **characterised in that** an increase of the upper limit is permitted only after a consistency check (E) of the detected power ageing with other detected parameters of the laser (2) or optical amplifier.

3. Control method according to Claim 2, **characterised in that** the operating temperature of the laser (2) or optical amplifier is detected as one of the other parameters.

4. Control method according to one of the preceding claims, **characterised in that** an increase of the upper limit is permitted only after a particular operating time of the laser (2) or optical amplifier.

5. Control method according to one of the preceding claims, **characterised in that** the value of the increased upper limit is stored (G).

6. Control method according to one of the preceding claims, **characterised in that** an increase of the upper limit is carried out only by a small amount in each case.

7. Optical emitter (1) having a laser (2) or an optical amplifier, a controller (4) for the operating power of the laser (2) or amplifier, a limiting circuit (5) which limits the operating power upwards, and an ageing monitor (6) of the laser (2) or optical amplifier, **characterised by** a control or regulating unit (7) which increases the upper limit for the maximum permissible operating power in the limiting circuit (5) with increasing power ageing according to the power ageing detected by the ageing monitor (6).

8. Optical emitter according to Claim 7, **characterised in that** the limiting circuit (5) has a current limiting resistor (R2) which can be adjusted by the control or regulating unit (7).

9. Optical emitter according to Claim 8, **characterised in that** the controllable current limiting resistor (R2) is connected in parallel with an invariable current limiting resistor (R1).

10. optical emitter according to one of Claims 7 to 9, **characterised by** a checking device (8) which checks a detected power ageing for consistency with other detected parameters of the laser (2) or optical amplifier, and sends the result to the control or regulating unit (7).
